# EUROPÄISCHE PATENTSCHRIFT

(11) **EP 3 289 619 B1**
(45) Veröffentlichungstag und Bekanntmachung des Hinweises auf die Patenterteilung: **08.01.2020**
(21) Anmeldenummer: 16725753.4
(22) Anmeldetag: 27.04.2016
(51) Int. Cl.: H01L 33/50, H01L 33/64, H01L 25/075, H01L 33/56

(54) **LED MODUL MIT VERBESSERTER WÄRMEABFUHR**
LED MODULE WITH IMPROVED HEAT DISSIPATION
MODULE À DEL AVEC DISSIPATION DE CHALEUR AMÉLIORÉE

(30) Priorität: 29.04.2015 DE 202015102142 U; 14.10.2015 DE 202015105428 U
(43) Veröffentlichungstag der Anmeldung: 07.03.2018
(73) Patentinhaber: Tridonic Jennersdorf GmbH, 8380 Jennersdorf (AT)
(72) Erfinder: PACHLER, Peter, 8042 Graz (AT)
(74) Vertreter: Rupp, Christian
(86) Internationale Anmeldenummer: PCT/AT2016/050113
(87) Internationale Veröffentlichungsnummer: WO 2016/172752

(56) Entgegenhaltungen:
- DE-A1-102010 054 280
- DE-A1-102010 061 848
- DE-A1-102012 203 180
- DE-A1-102013 207 579
- US-A1- 2011 227 108
- US-A1- 2013 050 982

## Beschreibung

### Gebiet der Erfindung

Die vorliegende Erfindung betrifft ein LED Modul mit wenigstens einem LED Chip und eine den LED Chip bedeckende Vergussmasse mit Leuchtstoffpartikel. Insbesondere betrifft die Erfindung ein LED Modul mit einer Vergussmasse mit Leuchtstoffpartikel, welche durch einen sogenanntes Absetzverfahren ("Settlement-Prozess") auf den LED Chip aufgetragen wird und welche eine verbesserte Wärmeabfuhr vom LED Chip ermöglicht.

### Hintergrund und Aufgabe der Erfindung

Aus dem Stand der Technik ist es bereits bekannt, LED Chips eines LED Moduls mit Farbkonversionspartikeln zu beschichten. Die Farbkonversionspartikel sind üblicherweise in eine Matrix aus zum Beispiel Silikonmaterial eingebracht. Der LED Chip kann dabei in einer Kavität einer Leiterplatte oder eines Trägersubstrats angeordnet sein, welche mit der die Farbkonversionspartikel enthaltenden Vergussmasse gefüllt ist. Die Farbkonversionspartikel wandeln dann im Betrieb des LED-Moduls das von dem LED-Chip ausgesandte Licht wenigstens teilweise um. Auf diese Weise können verschiedenartige LED-Module hergestellt werden, zum Beispiel ein LED-Modul das mischfarbiges Licht insbesondere weißes Licht abgibt.

Insbesondere zur Erzielung höherer Leuchtdichten ist aus dem Stand der Technik auch ein sogenanntes Absetz-Verfahren ("Settlement Verfahren") für den Leuchtstoffauftrag auf LED Chips bekannt. Hierbei weist das Herstellungsverfahren des LED-Moduls einen Prozessschritt auf, während dem sich Farbkonversionspartikel auf die Oberfläche des LED-Chips niederlassen bzw. in der Vergussmasse absinken. Dieses erfolgt, indem mit dem Aushärten der auf den LED Chip aufgetragenen Vergussmasse solange gewartet wird, bis sich die in der Vergussmasse befindlichen Farbkonversionspartikel unter Schwerkrafteinfluss auf die Oberfläche der LED Chips abgesenkt haben. Hierbei weisen die Partikel vorzugsweise eine höhere Dichte auf als das umgebende Medium. Um ein Absinken der Partikel zu ermöglichen, muss das umgebende Medium einen Transport in endlicher Zeit zulassen.

DE 10 2013 207579 A1 offenbart ein LED-Modul, aufweisend wenigstens ein LED-Chip auf einem Träger, und eine Leuchtstoffschicht, die auf der Lichtabstrahlfläche des LED-Chips aufgebracht ist, wobei in der Schicht die Leuchtstoffpartikel in einer Matrix anwesend sind, wobei die Konzentration der Leuchtstoffpartikel in einem ersten Bereich, das den LED-Chip bedeckt und/oder seitlich umgibt im wesentlichen konstant ist.

WO 2008/043519 beschreibt ein LED Modul mit einem LED Chip, auf welchen Phosphorpartikel mit Hilfe eines "Settlement-Prozesses" aufgetragen wurden. Auf dem LED Chip ist eine Schicht aus transparentem Vergussmaterial aufgetragen, welche als Matrixmaterial für darin vorhandene Farbkonversionspartikel fungiert. Der Konzentrationsgradient der Farbkonversionspartikel steigt von einer Oberfläche des Vergussmaterials hinzu dem LED Chip. Das von dem LED Chip emittierte blaue Licht wird wenigstens teilweise von den Farbkonversionspartikeln in Licht einer anderen Wellenlänge umgewandelt wird. Das LED Modul emittiert somit ein Mischlicht aus dem vom LED Chip abgegebenen blauen Primärlicht und einem von den Farbkonversionspartikel abgegebenen Sekundärlicht.

Die aus dem Stand der Technik bekannten LED Settlement Module weisen den Nachteil auf, dass diese nur bezüglich einer homogenen Lichtemission optimiert sind, nicht jedoch bezüglich des Thermomanagements, also der Wärmeabfuhr vom LED Chip und/oder vom LED Modul hin zu einer Leuchte in welcher das Modul verbaut ist. Insbesondere bei geringen Baugrößen der LED Module, welche durch einen geringen Aufnahmeplatz in einer Leuchte bedingt sein können, kann eine schlechte Wärmeabfuhr vom LED Chip zu negativen Auswirkungen auf die Lichtemission und/oder Lebensdauer des LED Chips führen. Auch kann durch eine schlechte thermische Anbindung zwischen LED Modul und Leuchte die Effizienz des LED Moduls sowie des LED Chips negativ beeinträchtigt sein.

Die vorliegende Erfindung hat daher die Aufgabe, basierend auf dem bekannte Stand der Technik ein LED Modul mit sedimentierten Leuchtstoffen bereitzustellen, welches hinsichtlich des Thermomanagements und der Effizienz optimiert ist. Diese Aufgabe wird erfindungsgemäß durch die Merkmale des unabhängigen Anspruchs gelöst. Die abhängigen Ansprüche bilden den zentralen Gedanken der Erfindung in besonders vorteilhafter Weise weiter.

### Beschreibung der Erfindung

In einem ersten Aspekt betrifft die vorliegende Erfindung ein LED Modul aufweisend einen Träger und wenigstens einen auf einer Oberfläche des Trägers angeordneten LED Chip, eine über dem LED Chip angeordnete Vergussmasse mit darin enthaltenen Farbkonversionspartikeln, welche sich von einer vom Träger abgewandten Oberseite des LED Chips zu einer definierten Höhe erstreckt, wobei die Farbkonversionspartikel innerhalb der Vergussmasse eine Schicht bilden, welche eine vom Träger abgewandte Oberseite des LED Chips und die den LED Chip umgebende Oberfläche des Trägers bedeckt, wobei die Höhe der Vergussmasse über dem wenigstens einen LED Chip zwischen 0.3 und 1.4 mm beträgt, und wobei die Vergussmasse derart ausgeprägt ist, dass diese eine Wärmeleitfähigkeit zwischen 0.1 und 1.5 W/mK, vorzugsweise zwischen 0.1 und 0.3 W/mK aufweist.

Die Farbkonversionspartikel sind vorzugsweise in der Vergussmasse sedimentierte Farbkonversionspartikel.

In einem bevorzugten Ausführungsbeispiel weist die Vergussmasse einen Teilbereich mit erhöhter Wärmeleitfähigkeit auf, welcher zwischen 0.1 und 1.5W/mK liegt, vorzugsweise zwischen 0.5 und 1.5W/mK oder zwischen 0.8 und 1.2W/mK. Insbesondere weist dieser Teilbereich eine relativ zur restlichen Vergussmasse erhöhte Wärmeleitfähigkeit auf. Der Teilbereich mit erhöhter Wärmeleitfähigkeit ist der Bereich der Vergussmasse, in welchem die Farbkonversionspartikel enthalten bzw. eingebettet sind. Der Teilbereich umfasst insbesondere die Schicht aus Farbkonversionspartikeln innerhalb der Vergussmasse. Auch die direkt an die Schicht aus Farbkonversionspartikeln angrenzenden Oberflächen der Vergussmasse können eine erhöhte Wärmeleitfähigkeit aufweisen.

Die restliche Vergussmasse, in welcher keine Farbkonversionspartikel angeordnet sind, weist vorzugsweise eine Wärmeleitfähigkeit zwischen 0.05 und 0.3W/mK auf.

Das erfindungsgemäße LED Modul ist ein sogenanntes "LED Settlement Modul", d.h. ein LED Modul, welches mit einem sogenannten Absetz-Verfahren hergestellt ist. Hierbei wird die Vergussmasse auf den LED Chip des Moduls in wenigstens teilweise flüssigem Zustand aufgebracht. Dies kann beispielsweise mit Hilfe eines Dispensverfahrens erfolgen, in welchem die Vergussmasse und die darin enthaltenen Farbkonversionspartikel auf den LED Chip aufgebracht wird. Nach dem Aufbringen der Vergussmasse sinken die Farbkonversionspartikel in der noch wenigstens teilweise flüssigen Vergussmasse schwerkraftbedingt nach unten, in Richtung des LED Chips und der Oberfläche des Trägers. Hierdurch entsteht eine Schicht von sedimentierten Farbkonversionspartikeln, welche auf der Oberfläche des LED Chips und einer den LED Chip umgebenden Oberfläche vorzugsweise direkt aufliegt. Hierbei kann wenigstens teilweise Vergussmasse bzw. Matrixmaterial zwischen der sedimentierten Schicht aus Farbkonversionspartikeln und der Oberfläche des LED Chips und/oder der Oberfläche des Trägers vorhanden sein. Nach dem Settlement-Prozess, erfolgt vorzugsweise eine Aushärtung der Vergussmasse. Die bevorzugte Wärmeleitfähigkeit der Vergussmasse gemäß der Erfindung liegt im ausgehärteten Zustand der Vergussmasse vor.

Das erfindungsgemäße LED Modul ermöglicht durch die gezielte Auswahl der über dem LED Chip angeordneten Höhe der Vergussmasse, welche eine definierte Wärmeleitfähigkeit aufweist eine verbesserte Wärmeabfuhr vom LED Chip, wodurch eine Effizienzsteigerung des LED Moduls erzielt wird. Das Vorhandensein von Vergussmasse mit der beschriebenen erhöhten Wärmeleitfähigkeit ermöglicht zusätzlich eine optimierte Wärmeabfuhr von den Farbkonversionspartikeln wie auch von der thermisch leitenden Vergussmasse bzw. Matrixmaterial. Die Wärme wird hierbei von dem Teilbereich der Vergussmasse mit erhöhter Wärmeleitfähigkeit in die umgebende Vergusmasse, wie auch in die Umgebung des LED Moduls abgegeben.

Dabei kann bei einer kleineren Emissionsfläche des LED Modules eine höhere Lichtleistung erzielt werden. Insbesondere ist ein thermischer Widerstand zwischen den Farbkonversionspartikeln, welche eine Wärmequelle des LED-Moduls darstellen da sie während der Farbkonversion Wärme erzeugen, und dem Träger, welcher als Wärmesenke fungieren kann, verringert. Das erfindungsgemäße LED Modul ermöglicht daher die Maximierung der Lichtleistung bei kleinerer Baugröße des Moduls. Hierbei wird vorzugsweise keine Aktivkühlung des LED-Moduls benötigt.

Die Schicht aus Farbkonversionspartikeln weist vorzugsweise eine homogene Stärke bzw. Dicke auf. Diese homogene Stärke bzw. Dicke liegt vorzugsweise wenigstens auf der ebenen Oberflächen des LED Chips und des umgebenen Trägers vor. Die Dicke der Schicht aus Farbkonversionspartikel in der Vergussmasse liegt zwischen 45 und 75 µm, bevorzugt zwischen 45 und 55 µm.

Bei einer geringen Dotierungsdichte der Leuchtstoffe und/oder hoher Umwandlungsrate, beispielsweise im Bereich von 3000K oder wärmer, kann die Dicke der Schicht höher sein, ist umgekehrt der Leuchtstoff hoch dotiert und die Umwandlungsrate gering , beispielweise im Bereich von 10.000K, dann kann die Dicke geringer sein.

Zusätzlich zu der Schicht aus Farbkonversionspartikeln, kann das Volumen der Vergussmasse noch weitere Farbkonversionspartikel aufweisen. Die Farbkonversionspartikel sind vorzugsweise ein anorganischer Leuchtstoff, welcher als Pulverpartikel vorliegt.

Die Höhe bzw. Dicke der über dem wenigstens einen LED Chip angeordneten Vergussmasse ist vorzugsweise konstant. Dies bedeutet, dass insbesondere die direkt über dem LED Chip angeordnete Vergussmasse sich von der Oberfläche zu einer definierten Höhe h erstreckt. Die Oberfläche der Vergussmasse über dem LED Chip ist dabei vorzugsweise parallel zu der Oberfläche des LED Chips. Die Höhe bzw. Dicke der Vergussmasse, welche über dem LED Chip angeordnet ist, kann alternativ leicht variieren, insbesondere wenn die Vergussmasse in Form eines Dispenstropfens auf dem LED Chip aufgebracht ist.

In einer bevorzugten Ausführungsform ist die Höhe der Vergussmasse über dem LED Chip zwischen 0.8 und 1.2 mm, vorzugsweise zwischen 0.9 und 1.1 mm.

Die Vergussmasse stellt vorzugsweise ein Matrixmaterial für die Farbkonversionspartikel dar. In einer bevorzugten Ausführungsform ist die Vergussmasse aus Silikon. Die Vergussmasse kann auch aus Epoxidharz sein.

In einer bevorzugten Ausführungsform bedeckt die Vergussmasse den wenigstens einen LED Chip sowie die den LED Chip seitlich umgebende Oberfläche des Trägers. Die Gesamtdicke der Vergussmasse, von der Oberfläche des Trägers bis hin zu einer dem Träger gegenüberliegenden Oberfläche der Vergussmasse kann zwischen 0.5 und 2.0 mm betragen. Die Gesamtdicke der Vergussmasse ist vorzugsweise konstant. Die Gesamtdicke kann alternativ leicht variieren, insbesondere wenn die Vergussmasse in Form eines Dispenstropfens auf dem LED Chip aufgebracht ist.

Der Träger ist vorzugsweise ein Trägersubstrat. Dieses kann eine Leiterplatte sein, auf welcher der wenigstens eine LED Chip in Chip-on-Board Technik aufgebracht ist. Der Träger kann aus FR4 oder CM3 Material bestehen. Der Träger kann auch ein IMS Material ("Insulated Metal surface-Material) sein. Dieses weist vorzugsweise eine Aluminium- oder Kupfer-Schicht und eine darüber angeordnete dielektrische Schicht auf. In einem weiteren bevorzugten Ausführungsbeispiel weist der Träger eine hochreflektierende Oberfläche auf, auf welcher eine Leiterplatte auflaminiert ist.

Die Materialstärke des Trägers liegt vorzugsweise zwischen 0,3 und 5mm, vorzugsweise zwischen 0,5 und 1,5mm.

Der Träger kann als Wärmesenke fungieren, um Wärme von dem wenigstens einen LED Chip nach außen abzuleiten.

Der Träger kann eine Kavität bzw. Aussparung aufweisen, in welcher der wenigstens eine LED Chip angeordnet ist. Die Kavität des Trägers kann kreisförmig oder ellipsoid sein. Der Durchmesser der kreisförmigen Kavität liegt vorzugsweise zwischen 7 und 50mm, vorzugsweise zwischen 10 und 30mm. Die Kavität kann eine vorzugsweise konstante Tiefe zwischen 0.1 und 1.5 mm aufweisen.

Die Dicke des wenigstens einen LED Chips kann zwischen 0.1 und 1 mm, vorzugsweise zwischen 0.1 und 0.2 mm liegen.

Das erfindungsgemäße LED Modul weist vorzugsweise eine Mehrzahl von LED Chips auf. Dabei kann die zwischen den einzelnen LED Chips liegende Oberfläche des Trägers mit der Schicht aus Farbkonversionspartikeln beschichtet sein.

Das LED Modul weist vorzugsweise zwischen 15 und 35 LED Chips auf, mehr bevorzugt zwischen 18 und 25 LED Chips.

### Kurzbeschreibung der Figuren

Weitere Vorteile, Merkmale und Eigenschaften der vorliegenden Erfindung sollen nunmehr bezugnehmend auf die Figuren der begleitenden Zeichnung näher erläutert werden.
- Fig. 1a: zeigt eine bevorzugte Ausführungsform eines erfindungsgemäßen LED Moduls in seitlicher Querschnittansicht.
- Fig. 1b: zeigt eine weitere bevorzugte Ausführungsform eines erfindungsgemäßen LED Moduls in seitlicher Querschnittansicht.
- Fig. 2a: zeigt eine thermische Analyse eines LED Moduls gemäß dem Stand der Technik in seitlicher Querschnittansicht.
- Fig. 2b: zeigt eine thermische Analyse eines erfindungsgemäßen LED Moduls in seitlicher Querschnittansicht.
- Fig. 3a: zeigt eine thermische Analyse eines weiteren erfindungsgemäßen LED Moduls in perspektivischer Seitenansicht.
- Fig. 3b: zeigt eine thermische Analyse des LED Moduls gemäß Figur 3a in perspektivischer Seitenansicht, wobei die Vergussmasse entfernt wurde.

### Detaillierte Figurenbeschreibung

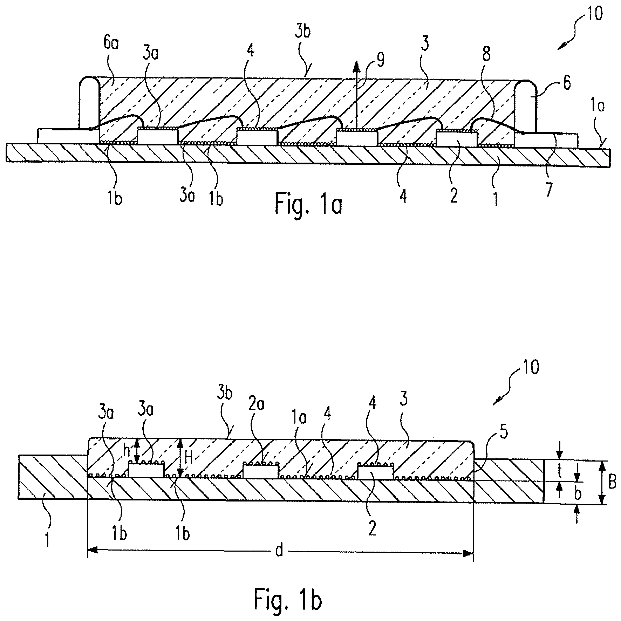

Die Figuren 1a und 1b zeigen bevorzugte Ausführungsformen eines erfindungsgemäßen LED Moduls 10 in seitlicher Querschnittansicht. Das LED Modul ist ein LED Modul, welches durch ein Absetz-Verfahren hergestellt wurde, aufweisend einen Träger 1 mit einer Oberfläche 1a, auf welcher vorzugsweise mehrere LED Chips 2 angeordnet sind. Der Träger 1 ist vorzugsweise ein Trägersubstrat, beispielsweise eine Leiterplatte. Die LED Chips 2 sind mit einer Vergussmasse 3 mit Farbkonversionspartikel 3a eingehüllt bzw. mit dieser vergossen. Das LED-Modul 10 kann mittels eines Verfahrens des Dämmens und Füllens ("Dam and Fill" Verfahren) hergestellt werden, bei welchem zunächst der Damm 6 auf der Leiterplatte 1 geformt wird und die dadurch entstehende Kavität 6a anschließend mit der Vergussmasse 3 gefüllt wird. Die LED Chips 2 können aber auch in einer Kavität 5 der Leiterplatte 2 angeordnet sein, wie dies in Figur 1b gezeigt ist. Die Vergussmasse 3 kann dabei die Kavität 5 vollständig ausfüllen oder aber wenigstens teilweise aus dieser nach oben herausragen, wie in Figur 1b gezeigt. Die Licht emittierende Oberfläche 3b der Vergussmasse 3 ist vorzugsweise parallel zu einer Oberfläche 1b der Kavität angeordnet.

Die LED Chips 2 sind vorzugsweise miteinander durch Bonddrähte 8 seriell verschaltet und an wenigstens zwei außerhalb des Dammes 6 angeordnete Bondpads 7 angeschlossen. Wie in Figur 1 gezeigt, sind die Farbkonversionspartikel 3a in dem LED Modul 10 nicht gleichmäßig in der Vergussmasse 3 verteilt, sondern bilden durch den bei der Herstellung des LED Moduls durchgeführten "Settlement-Prozess" bzw. Absetz-Verfahren eine Schicht 4 auf der Oberfläche 2a der jeweiligen LED Chips und der zwischen den LED Chips angeordneten Oberfläche 1b des Trägers 1. Die Schicht 4 aus Farbkonversionspartikeln 3a liegt vorzugsweise direkt auf der Oberfläche 2a der LED Chips bzw. der Oberfläche 1b des Trägers 1 auf. Es können jedoch auch zusätzliche Farbkonversionspartikel 3a in dem Volumen der Vergussmasse 3 vorhanden sein, welche nicht in der gezeigten Schicht 4 vorliegen. Die LED Chips 2 sind vorzugsweise komplett in der Vergussmasse 3 eingeschlossen bzw. von dieser komplett umgeben.

Die Schicht 4 aus Farbkonversionspartikeln 3a, welche sich auf der Oberfläche 2a der LED Chips 2 und der diese umgebenen Oberfläche 1b des Trägers 1 befindet ist vorzugsweise von homogener Stärke bzw. Dicke. Die Dicke der Schicht 4 aus Farbkonversionspartikeln 3a liegt zwischen 45 und 75 µm, bevorzugt zwischen 45 und 55 µm.

Ein von den LED Chips 2 emittiertes Licht wird von den Farbkonversionspartikeln 3a wenigstens teilweise in Licht einer anderer Wellenlänge umgewandelt. Das LED Modul 10 kann somit ein Mischlicht 9 aus einem Primärlicht der LED Chips 2 und einem Sekundärlicht der Farbkonversionspartikel 3a abgeben.

Die Höhe bzw. Dicke h der Vergussmasse 3 über den LED Chips 2 beträgt vorzugsweise zwischen 0.3 und 1.4 mm. Die Höhe h kann auch zwischen 0.8 und 1.2 mm betragen, mehr bevorzugt zwischen 0.9 und 1.1 mm.

Die Gesamthöhe bzw. -Dicke H der Vergussmasse 3, zwischen der Oberfläche 1b des Trägers und der lichtemittierenden Oberfläche 3b der Vergussmasse liegt vorzugsweise wischen 0.5 und 3.5 mm, vorzugsweise zwischen 0.5 und 2.0mm.

Eine Breite bzw. ein Durchmesser d der Kavität 5 liegt vorzugsweise zwischen 7 und 30mm, mehr bevorzugt zwischen 10 und 20mm. Die Kavität ist hierbei vorzugsweise kreisförmig.

Die Tiefe t der Kavität 5 liegt vorzugsweise zwischen 0.1 und 1.5 mm.

Eine Dicke bzw. Stärke b des Trägers 1 unterhalb der Kavität 5 liegt vorzugsweise zwischen 0.1 und 4mm, mehr bevorzugt zwischen 0.5 und 3mm. Der Träger 1 kann eine Gesamtdicke bzw. -Stärke B zwischen 0.8 und 5mm, mehr bevorzugt zwischen 1 und 3 mm aufweisen.

Die Wärmeleitfähigkeit der ausgehärteten Vergussmasse liegt zwischen 0.1 und 1.5 W/mK. Die Wärmeleitfähigkeit kann auch zwischen 0.5 und 1.2W/mK liegen. Hierbei weist die Vergussmasse vorzugsweise einen Teilbereich mit erhöhter Wärmeleitfähigkeit auf, welcher zwischen 0.1 und 1.5W/mK liegt, vorzugsweise zwischen 0.5 und 1.5W/mK oder zwischen 0.8 und 1.2W/mK. Insbesondere weist dieser Teilbereich eine relativ zur restlichen Vergussmasse erhöhte Wärmeleitfähigkeit auf. Der Teilbereich mit erhöhter Wärmeleitfähigkeit ist der Bereich der Vergussmasse, in welchem die Farbkonversionspartikel 3a enthalten bzw. eingebettet sind. Der Teilbereich umfasst insbesondere die Schicht aus Farbkonversionspartikeln innerhalb der Vergussmasse. Auch die direkt an die Schicht aus Farbkonversionspartikeln angrenzenden Oberflächen der Vergussmasse können eine erhöhte Wärmeleitfähigkeit aufweisen. Die restliche Vergussmasse, in welcher keine Farbkonversionspartikel angeordnet sind, weist vorzugsweise eine Wärmeleitfähigkeit zwischen 0.05 und 0.3W/mK auf.

Die Dicke der LED Chips 2 liegt zwischen 0.1 und 1 mm, vorzugsweise zwischen 0.1 und 0.2 mm.

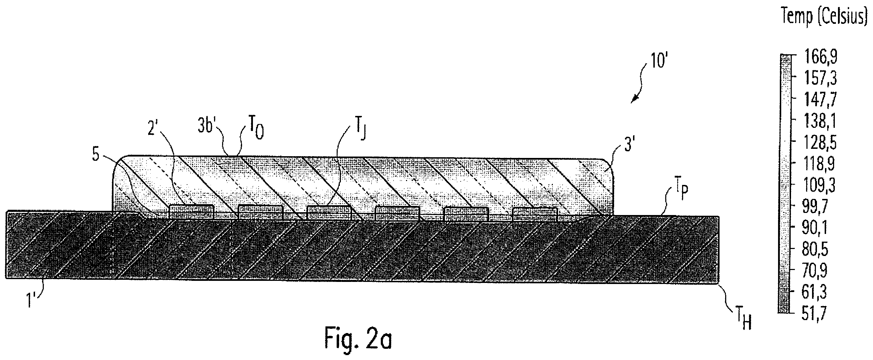

Figur 2a zeigt eine thermische Analyse eines LED Moduls 10' gemäß dem Stand der Technik in seitlicher Querschnittansicht. Das LED Modul 10' weist dabei mehrere in einer Kavität 5' angeordnete LED Chips 2' auf, welche mit einer Vergussmasse 3' vergossen sind. Die Vergussmasse 3' weist vorzugsweise homogen verteilte Farbkonversionspartikel auf, welche nicht durch einen Settlement-Prozess auf den LED Chips 2 beziehungsweise auf die dazwischen liegende Oberfläche des Trägers abgesunken sind. Die Höhe der Vergussmasse über den jeweiligen LED Chips 2' beträgt 0.7mm. Die Vergussmasse hat eine thermische Leitfähigkeit von etwa 0.2W/mK. Der Konvektionskoeffizient zwischen Vergussmasse 3' und umgebener Luft ist circa 10W/m²K.

Die Temperatur wurde während des bestimmungsgemäßen Gebrauchs des LED Moduls 10' an mehreren Stellen gemessen, wobei sich für die Oberfläche 3a' eine Temperatur von T_{O}=166,9°C ergibt. An der Oberfläche der LED Chips 2' liegt eine Temperatur von T_{J}=67,6°C vor. Auf der Oberfläche 1' des Trägers liegt eine Temperatur von TP=53,3°C vor. Die Temperatur der Rückseite des Trägers, welche als Wärmesenke fungiert liegt bei T_{H}=51,6°C. Gemäß der thermischen Analyse des Moduls 10' zeigt sich, dass die größte Hitzeentwicklung in einem Bereich der Vergussmasse 3' mittig und direkt oberhalb der LED Chips 2' vorliegt. Die gezeigte starke Hitzeentwicklung in der Vergussmasse 3' kann die Effizienz der LED Chips 2' und somit des gesamten LED Moduls 10' negativ beeinträchtigen.

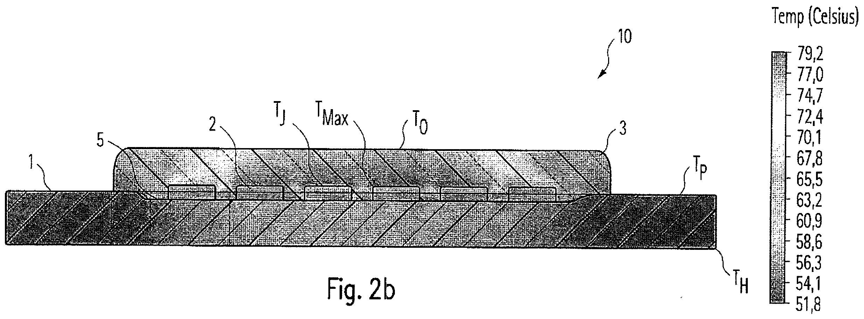

Figur 2b zeigt eine thermische Analyse eines erfindungsgemäßen LED Settlement Moduls 10, wie beispielswiese in Figuren 1a und 1b gezeigt, in seitlicher Querschnittansicht. Die Höhe der Vergussmasse über den jeweiligen LED Chips 2' beträgt hier ebenfalls 0.7 mm. Die Vergussmasse hat eine thermische Leitfähigkeit von etwa 0.2W/mK. Der Konvektionskoeffizient zwischen Vergussmasse 3 und umgebener Luft ist circa 10W/m²K.

Wie in der Figur 2b gezeigt, liegt durch die erfindungsgemäße Anordnung in Kombination mit der Füllhöhe h der Vergussmasse 3 über den LED Chips 2 und der gewählten thermischen Leitfähigkeit der Vergussmasse eine deutlich geringere Wärmeentwicklung innerhalb der Vergussmasse vor. Die Temperatur an der Oberfläche 3b der Vergussmasse T_{O} liegt hier bei nur 74,9°C. Die Temperatur auf dem LED Chips 2 liegt bei T_{J}=68,6°C. Die weiteren Temperaturen liegen bei Tp=53,4°C und T_{H}=51,8°C. Die maximal Temperatur T_{MAX}=79,2°C liegt an den Oberflächen-Kanten der LED Chips 2 an.

Die folgende Tabellen 1 und 2 zeigen weitere Beispiele für die gemessenen Temperaturen Tₘₐₓ, T_{J}, T_{O}, T_{P} und T_{H}, welche den in Figur 2a und 2b gezeigten Messpunkten entsprechen und welche bei dem bestimmungsgemäßen Gebrauch der erfindungsgemäßen LED Settelement Module auftreten. Die genannte Füllhöhe h entspricht dabei der Höhe der Vergussmasse über den LED Chips 2. Die Füllhöhe h und die Wärmeleitfähigkeit der Vergussmasse 3 wurde bei den Messungen variiert, wie unten gezeigt. Die Werte gemäß Tabelle 1 und 2 sind exemplarische Werte und zeigen besonders bevorzugte Ausführungsbeispiele der Erfindung.

Bei den gemessenen Werten liegt die Maximal-Temperatur T_{Max} jeweils an den Oberflächen-Kanten der LED Chips 2 an. Die Werte der Tabelle 1 wurden mit einem Konvektionskoeffizienten von 10W/m²K gemessen, die Werte in Tabelle 2 mit einem Konvektionskoeffizienten von 25W/m²K.

Wie bereits oben beschrieben, lag die Dicke der Schicht aus Farbkonversionspartikel 3a bei den gemessenen Modulen zwischen 35 und 75 µm, vorzugsweise zwischen 45 und 55 µm.

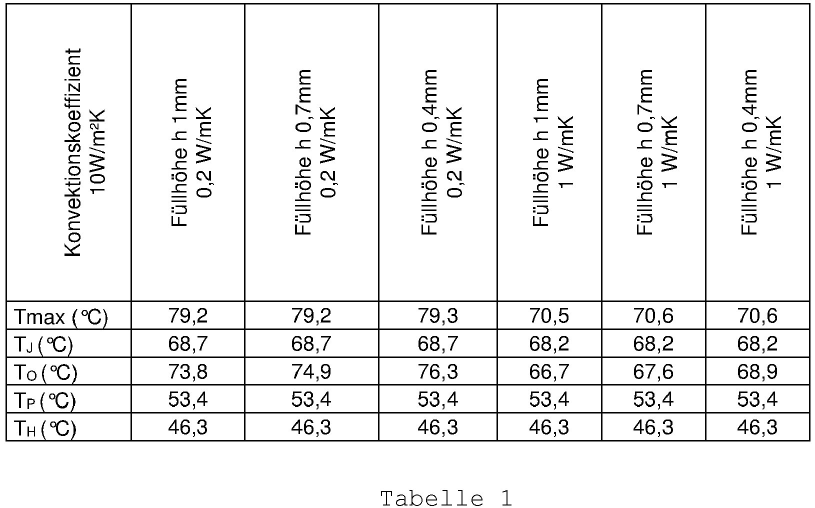

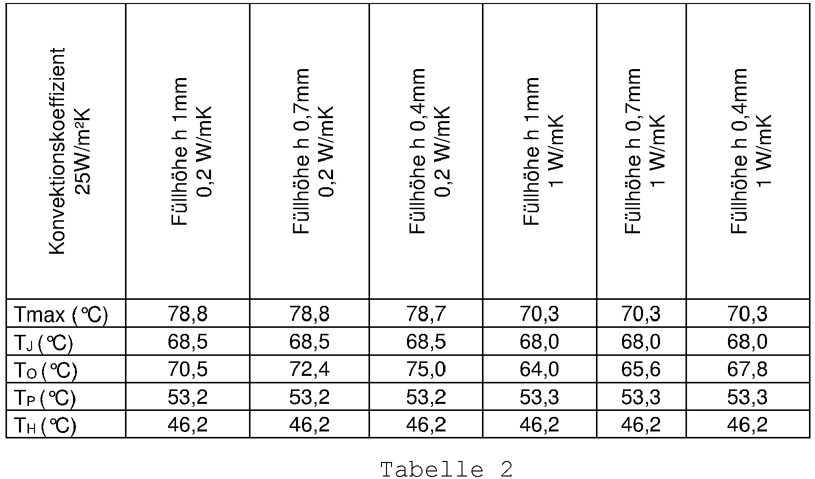

Wie in den Temperatur-Werten gemäß den Tabellen 1 und 2 gezeigt, wird durch ein erfindungsgemäßes LED Settlement Modul eine deutlich geringere Wärmeentwicklung vor allem in der Vergussmasse 3 und an deren Emissionsoberfläche 3b erzielt.

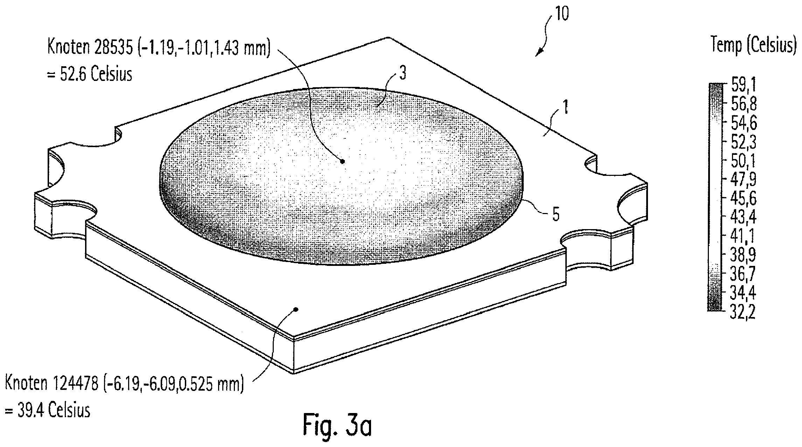

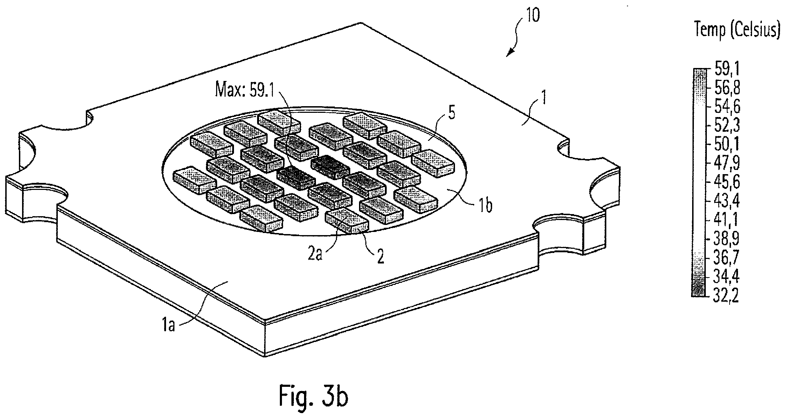

Figur 3a und 3b zeigen eine thermische Analyse eines weiteren erfindungsgemäßen LED Moduls 10 in perspektivischer Seitenansicht (Figur 3a) und mit entfernter Vergussmasse (Figur 3b). Wie in Figur 3a gezeigt, weist die Oberfläche der Vergussmasse 3 in diesem Beispiel eine Temperatur T_{O} von 52,6°C auf. Die Temperatur der Oberfläche 1a des Trägers T_{P} liegt bei 39,4°C. Die höchste Temperatur liegt auch in diesem Beispiel an der Oberflächenkante der in der Mitte der Vergussmasse angeordnete LED Chips 2. Diese liegt bei T_{Max}=59,1°C.

Die Erfindung wird durch die folgenden Ansprüche definiert.

## Patentansprüche

1. LED Modul (10) aufweisend
einen Träger (1) und wenigstens einen auf einer Oberfläche (1a) des Trägers angeordneten LED Chip (2),
eine über dem LED Chip (2) angeordnete Vergussmasse (3) mit darin enthaltenen sedimentierten Farbkonversionspartikeln (3a), welche sich von einer vom Träger abgewandten Oberseite (2a) des LED Chips (2) zu einer definierten Höhe (h) erstreckt,
wobei die Farbkonversionspartikel (3a) innerhalb der Vergussmasse (3) eine Schicht (4) bilden, welche eine vom Träger abgewandte Oberseite (2a) des LED Chips (2) und die den LED Chip umgebende Oberfläche (1b) des Trägers (1) bedeckt,
wobei die Höhe (h) der Vergussmasse über dem wenigstens einen LED Chip zwischen 0.3 und 1.4 mm beträgt,
wobei die Vergussmasse derart ausgeprägt ist, dass diese eine Wärmeleitfähigkeit zwischen 0.1 und 1.5 W/mK aufweist, **dadurch gekennzeichnet, dass** die Höhe (h) der Vergussmasse über dem wenigstens einen LED Chip zwischen 0.3 und 1.4 mm beträgt, und dass
die Schicht (4) aus Farbkonversionspartikel (3a) in der Vergussmasse (3) eine Dicke zwischen 45 und 75 µm, vorzugsweise zwischen 45 und 55 µm aufweist.

2. LED Modul gemäß Anspruch 1,
wobei die Vergussmasse einen Teilbereich mit erhöhter Wärmeleitfähigkeit aufweist, in welchem die Wärmeleitfähigkeit zwischen 0.1 und 1.5W/mK liegt, vorzugsweise zwischen 0.5 und 1.5W/mK,
wobei vorzugsweise der Teilbereich der Vergussmasse mit erhöhter Wärmeleitfähigkeit die Schicht aus Farbkonversionspartikeln (3a) umfasst.

3. LED Modul gemäß einem der vorhergehenden Ansprüche,
wobei die Schicht (4) aus Farbkonversionspartikeln (3a) innerhalb der Vergussmasse (3) eine homogene Stärke aufweist.

4. LED Modul gemäß einem der vorhergehenden Ansprüche,
wobei die Höhe (h) der Vergussmasse über dem LED Chip (2) zwischen 0.8 und 1.2 mm beträgt, vorzugsweise zwischen 0.9 und 1.1 mm.

5. LED Modul gemäß einem der vorhergehenden Ansprüche,
wobei die Vergussmasse (3) derart ausgeprägt ist, dass diese eine Wärmeleitfähigkeit zwischen 0.5 und 1.2 W/mK aufweist.

6. LED Modul gemäß einem der vorhergehenden Ansprüche,
wobei die Vergussmasse (3) ein Matrixmaterial für die Farbkonversionspartikel (3a) darstellt,
wobei vorzugsweise die Vergussmasse (3) eine Silikonmatrix ist.

7. LED Modul gemäß einem der vorhergehenden Ansprüche,
wobei die Höhe bzw. Dicke (h) der über dem wenigstens einen LED Chip (2) angeordneten Vergussmasse (3) konstant ist.

8. LED Modul gemäß einem der vorhergehenden Ansprüche,
wobei die Vergussmasse (3) den wenigstens einen LED Chip (2) sowie die den LED Chip seitlich umgebende Oberfläche (1b) des Trägers (1) bedeckt.

9. LED Modul gemäß einem der vorhergehenden Ansprüche,
wobei die Gesamthöhe- bzw. -dicke (H) der Vergussmasse (3), von der Oberfläche (1b) des Trägers (1) bis hin zu der dem Träger gegenüberliegenden Oberfläche (3b) der Vergussmasse (3) zwischen 0.5 und 3.5 mm, vorzugsweise zwischen 0.5 und 2.0 mm beträgt,
wobei vorzugsweise die Gesamthöhe- bzw. -dicke (H) der Vergussmasse (3) konstant ist.

10. LED Modul gemäß einem der vorhergehenden Ansprüche,
wobei das LED Modul (10) eine Mehrzahl von LED Chips (2) aufweist und die zwischen den einzelnen LED Chips liegende Oberfläche (1b) des Trägers (1) mit der Schicht (4) aus Farbkonversionspartikeln (3a) beschichtet ist.

11. LED Modul gemäß einem der vorhergehenden Ansprüche,
wobei der Träger (1) eine Kavität (5) aufweist, in welcher der wenigstens eine LED Chip (2) angeordnet ist,
wobei vorzugsweise die Kavität (5) des Trägers (1) eine kreisförmige Kavität ist, und
wobei vorzugsweise ein Durchmesser (d) der Kavität zwischen 7 und 30 mm, vorzugsweise zwischen 10 und 20mm liegt.

12. LED Modul gemäß einem der Ansprüche 11 oder 12,
wobei die Kavität (5) eine vorzugsweise konstante Tiefe (t) zwischen 0.1 und 1.5 mm aufweist.

13. LED Modul gemäß einem der vorhergehenden Ansprüche, wobei die Wärmeleitfähigkeit der Vergussmasse im ausgehärteten Zustand der Vergussmasse vorliegt.

## Claims

1. LED module (10) comprising
a substrate (1) and at least one LED chip (2) disposed on a surface (1a) of the substrate,
a casting compound (3) disposed above the LED chip (2) and containing sedimented color conversion particles (3a), which extends from an upper side (2a) of the LED chip (2) facing away from the substrate to a defined height (h),
wherein the color conversion particles (3a) within the casting compound (3) form a layer (4), which covers an upper side (2a) of the LED chip (2) facing away from the substrate and the surface (1b) of the substrate (1) surrounding the LED chip,
wherein the height (h) of the casting compound over the at least one LED chip is between 0.3 and 1.4 mm,
wherein the casting compound is such that it has a thermal conductivity between 0.1 and 1.5 W/mK, **characterized in that** the height (h) of the casting compound over the at least one LED chip is between 0.3 and 1.4 mm, and that
the layer (4) of color conversion particles (3a) in the casting compound (3) has a thickness between 45 and 75 µm, preferably between 45 and 55 µm.

2. LED module according to Claim 1,
wherein the casting compound comprises a section having increased thermal conductivity, in which the thermal conductivity is between 0.1 and 1.5 W/mK, preferably between 0.5 and 1.5 W/mK, wherein the section of the casting compound with increased thermal conductivity preferably includes the layer of color conversion particles (3a) .

3. LED module according to any one of the preceding Claims,
wherein the layer (4) of color conversion particles (3a) within the casting compound (3) has a homogeneous thickness.

4. LED module according to any one of the preceding Claims,
wherein the height (h) of the casting compound over the LED chip (2) is between 0.8 and 1.2 mm, preferably between 0.9 and 1.1 mm.

5. LED module according to any one of the preceding Claims,
wherein the casting compound (3) is such that it has a thermal conductivity between 0.5 and 1.2 W/mK.

6. LED module according to any one of the preceding Claims,
wherein the casting compound (3) represents a matrix material for the color conversion particles (3a),
wherein the casting compound (3) is preferably a silicone matrix.

7. LED module according to any one of the preceding Claims,
wherein the height or thickness (h) of the casting compound (3) disposed above the at least one LED chip (2) is constant.

8. LED module according to any one of the preceding Claims,
wherein the casting compound (3) covers the at least one LED chip (2) as well as the surface (1b) of the substrate (1) which laterally surrounds the LED chip.

9. LED module according to any one of the preceding Claims,
wherein the overall height or thickness (H) of the casting compound (3) from the surface (1b) of the substrate (1) to the surface (3b) of the casting compound (3) opposite to the substrate is between 0.5 and 3.5 mm, preferably between 0.5 and 2.0 mm,
wherein the overall height or thickness (H) of the casting compound (3) is preferably constant.

10. LED module according to any one of the preceding Claims,
wherein the LED module (10) comprises a plurality of LED chips (2) and the surface (1b) of the substrate (1) between the individual LED chips is coated with the layer (4) of color conversion particles (3a).

11. LED module according to any one of the preceding Claims,
wherein the substrate (1) comprises a cavity (5), in which the at least one LED chip (2) is disposed,
wherein the cavity (5) of the substrate (1) is preferably a circular cavity, and
wherein a diameter (d) of the cavity is preferably between 7 and 30 mm, preferably between 10 and 20 mm.

12. LED module according to any one of Claims 11 or 12,
wherein the cavity (5) has a preferably constant depth (t) between 0.1 and 1.5 mm.

13. LED module according to any one of the preceding Claims, wherein the thermal conductivity of the casting compound is present in the cured state of the casting compound.

## Revendications

1. Module LED (10) présentant
un support (1) et au moins une puce LED (2) disposée sur une surface (1a) dudit support, et
un composé d'enrobage (3) disposé sur la puce LED (2) et contenant des particules de conversion de couleur (3a) sédimentées, ledit composé d'enrobage s'étendant sur une hauteur définie (h) à partir d'une face supérieure (2a) de la puce LED (2) qui est opposée au support ;
les particules de conversion de couleur (3a) formant une couche (4) à l'intérieur du composé d'enrobage (3), laquelle recouvre une face supérieure (2a) de la puce LED (2) qui est opposée au support et la surface (lb) du support (1) qui entoure la puce LED,
ladite hauteur (h) du composé d'enrobage présent sur l'au moins une puce LED est comprise entre 0,3 et 1,4 mm,
ledit composé d'enrobage a pour caractéristique de présenter une conductivité thermique comprise entre 0,1 et 1,5 W/mK ; **caractérisé en ce que**
la hauteur (h) du composé d'enrobage présent sur l'au moins une puce LED est comprise entre 0,3 et 1,4 mm, et **en ce que**
la couche (4) constituée de particules de conversion de couleur (3a) à l'intérieur du composé d'enrobage (3) présente une épaisseur comprise entre 45 et 75 µm, de préférence entre 45 et 55 µm.

2. Module LED selon la revendication 1,
dans lequel le composé d'enrobage présente une sous-partie à conductivité thermique accrue dans laquelle la conductivité thermique est comprise entre 0,1 et 1,5 W/mK, de préférence entre 0,5 et 1,5 W/mK ,
ladite sous-partie du composé d'enrobage à conductivité thermique accrue comprenant la couche de particules de conversion de couleur (3a).

3. Module LED selon l'une des revendications précédentes,
dans lequel la couche (4) de particules de conversion de couleur (3a) présente une épaisseur homogène à l'intérieur du composé d'enrobage (3).

4. Module LED selon l'une des revendications précédentes,
dans lequel la hauteur (h) du composé d'enrobage présent sur la puce LED (2) est comprise entre 0,8 et 1,2 mm, de préférence entre 0,9 et 1,1 mm.

5. Module LED selon l'une des revendications précédentes,
dans lequel le composé d'enrobage (3) a pour caractéristique de présenter une conductivité thermique comprise entre 0,5 et 1,2 W/mK.

6. Module LED selon l'une des revendications précédentes,
dans lequel le composé d'enrobage (3) est un matériau matriciel pour les particules de conversion de couleur (3a), et
dans lequel le composé d'enrobage (3) constitue de préférence une matrice de silicone.

7. Module LED selon l'une des revendications précédentes,
dans lequel la hauteur ou l'épaisseur (h) du composé d'enrobage (3) présent sur l'au moins une puce LED (2) est constante.

8. Module LED selon l'une des revendications précédentes,
dans lequel le composé d'enrobage (3) recouvre l'au moins une puce LED (2) ainsi que la surface (lb) du support (1) qui entoure latéralement la puce LED.

9. Module LED selon l'une des revendications précédentes,
dans lequel la hauteur totale ou l'épaisseur totale (H) du composé d'enrobage (3), de la surface (lb) du support (1) jusqu'à la surface (3b) du composé d'enrobage (3) qui est opposée au support, est comprise entre 0,5 et 3,5 mm, de préférence entre 0,5 et 2,0 mm,
ladite hauteur totale ou épaisseur totale (H) du composé d'enrobage (3) étant de préférence constante.

10. Module LED selon l'une des revendications précédentes,
dans lequel le module LED (10) présente une pluralité de puces LED (2) et la surface (1b) du support (1) située entre les diverses puces LED est revêtue de ladite couche (4) de particules de conversion de couleur (3a).

11. Module LED selon l'une des revendications précédentes,
dans lequel le support (1) présente une cavité (5) dans laquelle est disposée l'au moins une puce LED (2),
ladite cavité (5) du support (1) étant de préférence circulaire, et
le diamètre (d) de la cavité étant de préférence compris entre 7 et 30 mm, de préférence entre 10 et 20 mm.

12. Module LED selon l'une des revendications 11 et 12,
dans lequel la cavité (5) a une profondeur (t) de préférence constante comprise entre 0,1 et 1,5 mm.

13. Module LED selon l'une des revendications précédentes, dans lequel la conductivité thermique du composé d'enrobage est réalisée à l'état durci du composé d'enrobage.
